# EUROPEAN PATENT SPECIFICATION

(11) **EP 1 709 739 B1**
(45) Date of publication and mention of the grant of the patent: **02.09.2009**
(21) Application number: 04804473.9
(22) Date of filing: 30.12.2004
(51) Int. Cl.: H03K 17/0812

(54) **OPERATING AN ELECTRONIC VALVE**
BETRIEB EINES ELEKTRONISCHEN VENTILS
MISE EN OEUVRE D'UNE VANNE ELECTRONIQUE

(30) Priority: 28.01.2004 GB 0401827
(43) Date of publication of application: 11.10.2006
(73) Proprietor: Bombardier Transportation GmbH, 10785 Berlin (DE)
(72) Inventor: CHANDRAMOULI, Ganesh, H., S-722 19 Väster s (SE); BELWON, Waldemar, A., S-722 41 Väster s (SE)
(74) Representative: Brunotte, Joachim Wilhelm Eberhard
(86) International application number: PCT/EP2004/014891
(87) International publication number: WO 2005/076475

(56) References cited:
- EP-A- 0 420 582
- FR-A- 2 717 323
- PATENT ABSTRACTS OF JAPAN vol. 1997, no. 09, 30 September 1997 (1997-09-30) & JP 09 121554 A (TOSHIBA ENG CO LTD; TOSHIBA CORP), 6 May 1997 (1997-05-06)
- HAMMERTON C: "TOPFET - A NEW CONCEPT IN PROTECTED MOSFET" ELECTRONIC COMPONENTS AND APPLICATIONS, PHILIPS, EINDHOVEN, NL, vol. 10, no. 4, January 1992 (1992-01), pages 153-168, XP000304697 ISSN: 0141-6219

## Description

The invention relates to a method of operating an electronic valve having an insulated gate, in particular of operating an IGBT (Insulated Gate Bipolar Transistor). More particularly, the invention relates to high-power converters comprising such valves, e.g. for delivering electric energy to a driving motor of a railroad traction vehicle. Furthermore, the invention relates to a corresponding arrangement. The term "gate" includes any insulated control electrode which is used to control the switching state of the valve.

Controlling the valves by means of pulse signals generated by a control device is well known in the art. In particular, a first edge of a pulse signal initiates a process of switching-on of at least one of the valves, and a second edge of the pulse signal initiates a process of switching-off of at least one of the valves. The first edge may be defined through a step-like increase of a voltage from a low potential to a high potential at a control signal input of a driver circuit, or by a transition from dark to light (in case of a light pulse) at a control signal input. The second edge may be defined by a step-like decrease of the voltage from a high potential to a low potential at the control signal input, or by a transition from light to dark at the control signal input. In particular, the initiation of the switching process causes a current flow to or from the gate, whereby the gate is charged or discharged and, as a result, a current flow through the valve is enabled or disabled. Furthermore, it is possible to initiate the first process of switching on the valve by a first pulse signal, and to initiate the second process of switching off the valve by a second pulse signal.

EP 0420582 A describes a drive circuit for a semiconductor device. The drive circuit comprises an ON gate drive means for supplying an ON control signal to a control electrode of the semiconductor device which performs a current switching and comprises an OFF gate drive means for supplying an OFF control signal to the control electrode of the semiconductor device;

If the on-time is very short ( i.e. the time interval from switching on to switching off), an IGBT does not reach saturation. This results in a more rapid switch-off when compared with a long on-time. This rapid switch-off can lead to undesirably high voltage transients, which may result in unacceptable electromagnetic interference with other components of an arrangement of electrical or electronic parts and devices, and might even result in damage or destruction of an IGBT. Thus, minimum values for the on-time have been defined to ensure a safe operation of the IGBT. Restrictions on the performance of the arrangement (in particular of the converter and thereby a load) are implied.

A control strategy for controlling the processes of switching on and switching off a valve is usually designed and optimised for on-times which are significantly longer than the minimum on-time, since long on-times occur more often than short on-times. The optimisation is intended to minimise switch-off losses while keeping voltage transients within allowable limits. During short on-times, the rapid process of switching off the valve may cause the voltage transients to exceed these limits. One way to avoid this is to adapt the control strategy by slowing down the switching-off process. In particular, the current flow from the gate may be reduced. However, this will result in increased switch-off losses for longer on-times. This will thereby reduce the effectiveness of a system which comprises the valve. Nevertheless, in many applications it is desirable to have short on-times, at least in certain modes of operation. This means that restrictions on minimum on-time duration can therefore also lead to a reduced performance of the system.

It is an object of the present invention to provide a method and an arrangement of the kind indicated above which allow a reduction of the minimum on-time without reducing the overall performance of the system.

The accompanying claims define the scope of protection.

It is proposed to perform the process of the switching-off the valve, wherein the way of performing the process is dependent on the time elapsed between the switching on and the switching off of the valve. The process of switching-off the valve may be varied depending on the time elapsed from an initiation of a first process (a process performed in order to switch on the valve) or from a characteristic point in time of the first process. The gate current as a function of time may be manipulated depending on a measured value of the time elapsed. In particular, the time elapsed from an occurrence of a switch-on-command may be measured. For example, the occurrence of the switch-on-command takes place at the time when the command (e.g. a first edge of a pulse signal) is received by a driver device for driving (e.g. charging and/or discharging) the gate of the valve.

According to a preferred embodiment of the invention, the time elapsed up until the occurrence of a switch-off-command is compared to a comparison value. One of a plurality of switching-off strategies is then chosen, depending on the result of the comparison. Thus, it is possible to choose an appropriate strategy for at least short on-times on one hand and long on-times on the other. In particular, the method according to the invention is performed for each cycle of a plurality of consecutive switch-on/switch-off cycles of the valve.

Furthermore, the following is proposed: A method of operating an electronic valve having an insulated gate, in particular of operating an Insulated Gate Bipolar Transistor, wherein
- a first process is performed in order to switch on the valve,
- a second process is performed in order to switch off the valve,
- the second process is selected from at least two procedures, wherein a time elapsed from an initiation of the first process or from a characteristic point in time of the first process is taken into account when the procedure is selected, and
- the at least two procedures differ with respect to a gate current as a function of time.

Preferably, the time elapsed from the initiation of the first process or from the characteristic point in time of the first process is measured and a measured value of the time elapsed is taken into account when the procedure is selected. However, it is also possible to provide an arrangement which is capable of performing the at least two procedures and to modify a setting of the arrangement after a fixed time has elapsed from switching on the valve, for example, so that a first of the procedures is performed if the fixed time has not elapsed yet and so that a second of the procedures is performed if the fixed time has elapsed.

The electronic valve may be any valve having an insulated gate or electrode for controlling the switch state of the valve. Besides IGBTs, Metal Oxide Field-Effect Transistors (MOSFETs) have such an electrode, for example. However, IGBTs are preferred for high-power applications, such as converters used to provide electric energy to power consumers like driving motors or industrial machines.

The procedures or strategies for optimising the switching-off process have been discussed in detail in many publications before the invention. However, manufacturers of the valves recommend to switch off the valve not before a minimum on-time has elapsed. For example, a typical minimum on-time is 10 µs for an IGBT. With the invention, it is now possible to optimise the switching-off process for at least two different on-times. The best switching-off strategy depends on the state after the switching-on of the valve. The time elapsed is a good measure for the state of the valve, in particular with regard to the question of whether the valve has reached the state of saturation, and can therefore be used for choosing the appropriate switching-off procedure. On the other hand, the time elapsed can be measured reliably and the effort of measuring is small. Examples will be given in more detail later. As a result of the invention, shorter on-times (in particular shorter than the minimum on-time recommended by the manufacturer) are possible, so that new control strategies for controlling a converter can be applied.

The switching-off procedures for long on-times (in particular on-times that are longer than the minimum on-time recommended by the manufacturer) are known in the art and do not need to be explained here in detail. One way to perform the switching-off procedure for short on-times (in particular on-times that are shorter than the minimum on-time recommended by the manufacturer) is to switch-off the valve at a lower switching speed compared to the switching speed for longer on-times. For example, the discharging current from the gate can be reduced by using a resistor with higher resistance.

Another approach of controlling the switching speed, which is preferred for the present invention, is described in WO 00/10243. According to this document a current source amplifier for controlling a value of a current to or from the gate is connected to the gate. The current source amplifier is digitally controlled. With this arrangement it is possible to pre-program a number of procedures for charging and/or discharging the gate, wherein each procedure comprises a number of consecutive time intervals and wherein the value (level) of the gate current is defined for each time interval of the corresponding procedure. Depending on the defined levels the gate can be discharged in a different manner so that the switching speed is lower or higher. Furthermore, each procedure can be optimised for a specific operating situation of the valve such as a specific on-time or range of on-times. In particular, it is possible to find a good compromise between switching losses and switching speed for each operating situation. For very short on-times it is possible to pre-program such a procedure so that the collector-emitter voltage, the collector current, a derivative of the voltage and/or a derivative of the current is/are kept within defined limits.

In particular, a first of the at least two procedures is adapted to minimise electrical switching losses while maintaining a changing rate and/or a peak value of an electric voltage at the valve, or at a driver circuit for controlling an operation of the valve, in particular a collector-emitter voltage within (a) specified limit(s) during the second process, wherein the first procedure is selected if the elapsed time is longer than a threshold value, or if it is longer than or equal to a threshold value.

Alternatively or in addition, it is preferred that a second of the at least two procedures is adapted to maintain a changing rate and/or a peak value of an electric voltage at the valve, or at a driver circuit for controlling an operation of the valve, in particular a collector-emitter voltage within (a) specified limit(s) during the second process, wherein the second procedure is selected if the elapsed time is shorter than a threshold value, or if it is shorter than or equal to a threshold value.

Preferably, the threshold value is chosen so that the valve has reached saturation, if the time elapsed is longer than the threshold value. However, the threshold values may be adapted during operation of the valve. In particular, a controlling device for controlling the operation may choose the threshold value depending on a load connected to a converter, which comprises the valve, and/or depending on a method of calculating pulse signals which are transferred to the driver of the valve (e.g. pulse width modulation).

The first process may be initiated by a control signal, in particular a first edge of a pulse signal, which is transferred to a driver device for driving the gate, wherein the elapsed time starts at receipt of the control signal at the driver device. The receipt of the control signal can easily be used e. g. to trigger the measurement of the elapsed time, for example by transferring the control signal to a trigger signal input of a counter adapted to -count clock signal pulses.

As mentioned earlier, it is preferred to compare the time elapsed to a comparison value, and to select a first of the at least two procedures, if the time elapsed at an initiation of the second process is longer than the comparison value, or if it is longer than or equal to the comparison value.
Additional information concerning an operating state of the valve may be taken into account when selecting the procedure of the second process. For example, it might be detected that the collector-emitter-voltage of an IGBT has decreased below a saturation voltage level during the first process. As a result, since the IGBT is saturated, a procedure may be selected which will lead to a higher gate current for switching-off the IGBT compared to the case that the collector-emitter-voltage is greater than the saturation voltage.

Furthermore it is possible to detect or measure when a defined operating state (such as the decrease of the collector-emitter-voltage to the saturation voltage level) has occurred. This type of additional information can be combined with the information about the time elapsed from an initiation of the first process or from a characteristic point in time of the first process and an appropriate procedure may be selected for the second process.

It is also proposed to provide an arrangement for operating an electronic valve having an insulated gate, in particular for operating an Insulated Gate Bipolar Transistor, wherein the arrangement comprises:
- a measuring device adapted to measure a time elapsed from an initiation of a first process or from a characteristic point in time of the first process, wherein the first process is to be performed for switching on the valve,
- a driver device adapted to perform at least a part of a second process, wherein the second process is to be performed for switching off the valve,
- a selecting device, which is connected to the measuring device and to the driver device, wherein the selecting device is adapted to select an operation of the driver device, depending on a measurement signal received from the measuring device.

In particular, the driver device may comprise a first driver unit adapted to perform at least a part of the second process, and may comprise a second driver unit adapted to perform the second process or at least a part of the second process in a different manner than the first driver unit. The arrangement may comprise a gate connection for discharging and/or charging the gate, wherein the first driver unit and the second driver unit are connected to the gate connection.

More particularly, the driver device may comprise standard components such as resistive gate driver units and/or gate driver units, which are adapted to control an electric current to or from the gate according to a pre-set control strategy. In this case, a plurality of such driver units may be provided for driving the same gate. These driver units may be used to perform the selected operation of the driver in one or more than one of the following ways, for example:
- One of a plurality of redundant driver units may be selected to perform at least a part of the second process of the switching-off of the valve. In this case, the redundant driver units are adapted to drive the gate in a different manner. For example, the resistances of two redundant resistive driver units are different, so that the current to or from the gate during a charging or discharging process is influenced in a different manner.
- A different combination of the redundant driver units may be selected. For example, a first of two redundant resistive driver units may be selected if the elapsed time is smaller than a threshold value, and both redundant resistive driver units may be selected if the time elapsed is greater than, or equal to the threshold value.
- A first of the driver units may be used to drive the gate during a first phase of the switching process, and a second of the units may be used to drive the gate during a second phase of the switching process. In this case, a duration of the first phase and/or a duration of the second phase may be adapted according to the selected operation of the driver.

There are different ways to operate the driver units according to the operation of the driver device which has been selected by the selecting device. In a preferred embodiment, at least one of a plurality of driver units is controlled by an AND-device, adapted to output a signal depending on the result of a logical AND-operation of two input signals, wherein the AND-device is connected to the selecting device and to a signal input, adapted to receive a control signal for controlling, and in particular initiating, the second process. For example, the signal input may be connected to the measuring device.

It is also proposed to provide the following:
An arrangement for operating an electronic valve having an insulated gate, in particular for operating an Insulated Gate Bipolar Transistor, wherein the arrangement comprises:
   - a measuring device adapted to measure a time elapsed from an initiation of a first process or from a characteristic point in time of the first process, wherein the first process is to be performed for switching on the valve,
   - a driver device adapted to perform at least a part of a second process, wherein the second process is to be performed for switching off the valve,
   - a manipulating device, which is connected to the measuring device and to the driver device, wherein the manipulating device is adapted to cause the driver device to manipulate a gate current as a function of time during the second process, depending on an output signal of the measuring device.

The manipulating device does not necessarily have to select one of at least two predefined control strategies. Rather, the gate current can be manipulated individually for each switching cycle, depending on the time elapsed and, optionally, depending on additional information about the operating state of the valve, for example depending on a value of a voltage between a collector and an emitter of the valve. However, the use of such additional information is not restricted to this arrangement.

Furthermore, the present invention includes a converter for converting a current, in particular for a high power application such as providing electric energy to a driving motor of a railroad traction vehicle. The converter comprises the arrangement according to one of the embodiments described above, wherein the converter can be operated by repeatedly switching the valve on and off, and wherein the arrangement and the gate are connected to each other via a gate connection for discharging and or charging the gate.

Preferred embodiments of the invention will be described in more detail, referring to the accompanying schematic drawing. However, the following description is not intended to limit the scope of protection of the invention. In the drawing, the same reference numerals are used for identical parts or units and for parts or units with similar function. The figures of the drawing show:
- Fig. 1: a preferred arrangement for operating an electronic valve;
- Fig. 2: a converter comprising the arrangement shown in Fig. 1;
- Fig. 3: a specific embodiment of the arrangement shown in Fig. 1;
- Fig. 4: a diagram showing a gate current and a gate voltage as a function of time for a switching cycle of an IGBT;
- Fig. 5: a diagram showing one of a plurality of consecutive pulse signals corresponding to the gate current and the gate voltage shown in Fig. 4;
- Fig. 6: a diagram showing a current carried by an electronic valve as well as a voltage across the electronic valve as functions of time during switching-off of the valve; and
- Fig. 7: a diagram showing a current carried by an electronic valve as well as a voltage across the electronic valve as functions of time during switching-off of the valve, wherein the switching-off procedure is optimised according to invention.

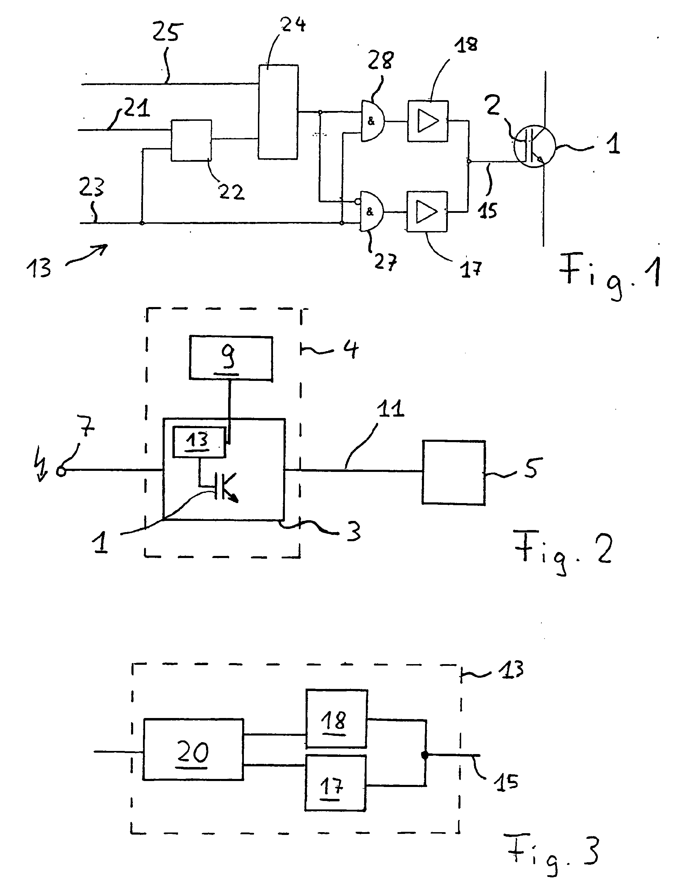

The arrangement 13 shown in Fig. 1 comprises a measuring device 22, a selecting device 24, a first AND-device 27, a second AND-device 28, a first driver unit 17 and a second driver unit 18. The arrangement 13 is adapted to drive a gate 2 of an IGBT 1. A control signal input 23 of the arrangement 13 is connected to the measuring device 22 and to the first and the second AND-devices 27, 28. Furthermore, the measuring device comprises a clock signal input 21 for receiving a clock signal from a clock signal generator (not shown in the figure). An output of the measuring device 22 is connected to the selecting device 24, which comprises a set signal input for receiving a set signal in order to set a threshold value. An output of the selecting device 24 is connected to the first and the second AND-devices 27, 28. An output of the first AND-device 27 is connected to an input of the first driver unit 17. An output of the second AND-device 28 is connected to an input of the second driver unit 18. Outputs of the first and the second driver units 17, 18 are connected to a gate connection 15 for connecting the driver units 17, 18 to the gate 2.

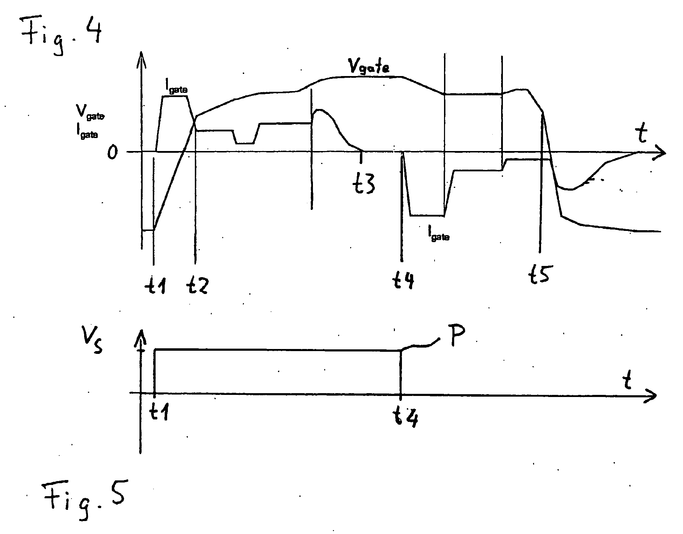

During operation of the arrangement 13 shown in Fig. 1, a control signal is repeatedly input via the control signal input 23. In this preferred embodiment, the control signal is a pulse signal, the duration of which defines a length of a switching cycle of the IGBT 1. As shown in Fig. 5, the pulse signal exhibits a rectangular shape. At a time t1, the voltage Vs at the control signal input 23 performs a step-like increase from a low level to a high level.

This step-like edge initiates a process of switching-on the IGBT 1, as can be seen from the graphs shown in Fig. 4. Starting at time t1, a current I_{gate} which charges the gate 2 starts rising from zero to positive values. As a result, the gate voltage V_{gate} starts rising from a negative value towards positive values. In particular, the voltage V_{gate} is the voltage between the gate 2 and an emitter of the IGBT 1. The gate current I_{gate} is controlled so that it exhibits the profile shown in Fig. 4. At time t2, the gate voltage V_{gate} reaches a value where the valve opens, i.e. a current can flow through the valve from its emitter to its collector. At time t3, the valve is fully open and it is no longer necessary to charge the gate 2. Consequently, the gate current I_{gate} is controlled to become zero at time t3. This process of switching on the valve is performed by units and/or devices which are not shown in Fig. 1. However, the edge of the voltage signal V_{S} at time t1 triggers a measuring process performed by the measuring device 22. During the measuring process, the measuring device 22 counts every clock signal pulse at the clock signal input 21 and thereby measures the time elapsed since time t1. At time t4, the pulse signal P performs a step-like decrease from the high voltage level to the low voltage level. This edge triggers the termination of the measuring process, so that the elapsed time since time t1 is determined and a corresponding measuring signal is transferred to the selecting device 24, which compares the elapsed time with a threshold value. The threshold value may correspond to a signal which is permanently or repeatedly present at the set signal input 25, or it may correspond to a numerical value, saved in the selecting device 24 according to a set signal which has been received earlier.

If the elapsed time is greater than the threshold value, a voltage signal at a high-level is output by the selecting device to the first and the second AND-device 27, 28. As indicated by a small circle at the input of the first AND-device 27, the high-level signal is inverted so that two low level signals are combined, and so that the first AND-device 27 triggers the first driver unit 17 to discharge the gate 2 via the gate connection 15 shown in Fig. 1.

If the elapsed time is smaller than or equal to the threshold value, the selecting device 24 outputs a low level voltage signal to the first and the second AND-device 27, 28. As a result, two low level signals are input to the second AND-device 28, and the device triggers the discharging of the gate 2 via the gate connection 15 in a different manner compared to the first driver unit 17.

In Fig. 4, the discharging process which is triggered by the first driver unit 17 is shown. At time t4, the discharging process is started by decreasing the gate current I_{gate} from zero to negative values. As a result, the gate voltage V_{gate} starts decreasing, and, at time t5, it reaches a voltage level which shuts the valve, i.e. prevents any further current flow through the valve from its emitter to its collector.

Fig. 2 shows a converter 3 which comprises a plurality of valves, one of which is indicated by reference numeral 1. Each of the valve's gates is connected to a driver arrangement 13, for example to the driver arrangement 13 shown in Fig. 1. There maybe more than one driver arrangements, and at least one of the arrangements may drive more than one of the gates. Corresponding parts of a complete driver device for driving the gates are omitted in Fig. 2. The driver arrangement 13 is connected to a controlling device 9 for controlling the operation of the valves and, thereby, of the converter 3. The controlling device and the converter 3 may be part of the same mechanical unit 4, for example a unit of a plurality of devices which are mechanically connected to each other. In particular, the mechanical unit 4 may comprise a cooling device for cooling the valves.

The converter 3 may comprise an energy supply connection for connecting the converter 3 to a direct current intermediate circuit or to an alternating current energy supply network (shown in Fig. 2). Furthermore, the converter 3 may be connected to a load 5 (such as a driving motor of a railroad traction vehicle) via a load connection 11.

As shown in Fig. 3, the arrangement 13 of Fig. 1 and/or Fig. 2 may comprise a programmable logic device (PLD) which includes the measuring device, the selecting device and any further device for triggering the operation of the first and second driver units 17, 18 (in particular the first and second AND-devices 27, 28, shown in figure 1). The PLD 20 may include further units and/or devices, and/or may be adapted to perform further functions, such as driving the gate of the valve during the process of switching on, or such as driving all the gates of the valves of the converter 3. The first and the second driver units 17, 18, which are shown in Fig. 1 and in Fig. 3 as separate units, may be part of the same unit and/or may partly use the same circuitry and/or electronic elements.

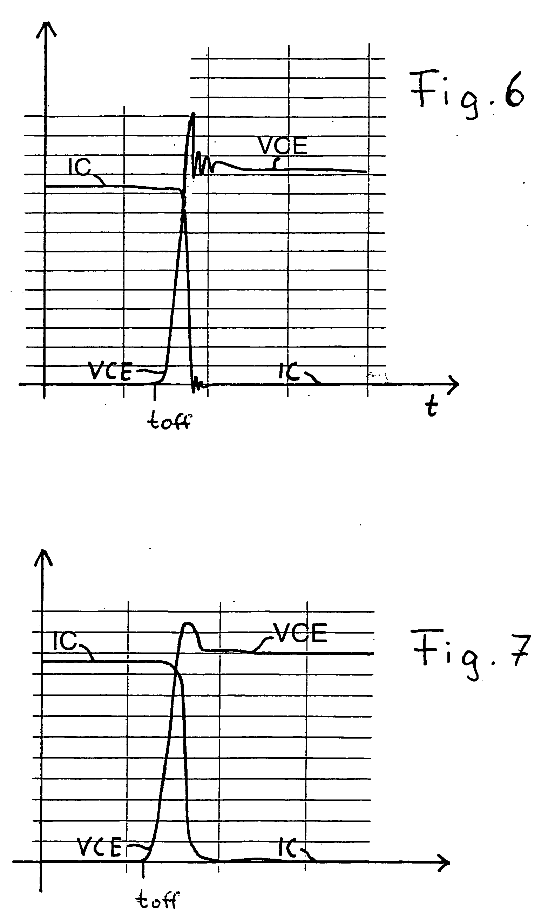

Figures 6 and 7 illustrate the effect of the invention for short times (e. g. the less than 10 µs) elapsed between switching on and switching off an electronic valve. In Fig. 6 the step-like decreasing line corresponds to the current IC carried by the valve (the collector-emitter current of an IGBT, for example). After time toff it drops down to zero due to the switching-off procedure performed. The step-like increasing line corresponds to the voltage VCE across the valve, i. e. between the two electrodes connecting the valve to the electric line which is to be interrupted or connected by switching the valve. The voltage VCE increases correspondingly to the decrease of the current IC.

Since the switching-off procedure is not optimised for short on-times, there are oscillations of the voltage VCE and of the current IC. In particular, the voltage VCE reaches a maximum value which is much higher than the nearly constant voltage level after the switching-off process. Furthermore, there are high values of the derivative of the voltage VCE as a function of time. Interference with other electronic or electric devices as well as destruction of the valve might occur.

Fig. 7 shows the diagram corresponding to Fig. 6. However, the process of switching-off of the valve has been optimised according to the invention and, therefore, there is only one small peak of the voltage VCE. The derivatives of the voltage VCE are significantly smaller.

## Claims

1. A method of operating an electronic valve (1) having an insulated gate (2), in particular of operating an Insulated Gate Bipolar Transistor, wherein
- a first process is performed in order to switch on the valve (1),
- a second process is performed in order to switch off the valve (1),
**characterized in that**
- the second process is varied depending on the time elapsed from an initiation of the first process or from a characteristic point in time of the first process.

2. The method of the preceding claim, wherein a gate current as a function of time is manipulated depending on a measured value of the time elapsed.

3. The method of claim 1 or 2, wherein the second process is selected from at least two procedures, wherein the time elapsed from an initiation of the first process or from a characteristic point in time of the first process is taken into account when the procedure is selected and wherein the at least two procedures differ with respect to a gate current as a function of time.

4. The method of claim 3, wherein the time elapsed from the initiation of the first process or from the characteristic point in time of the first process is measured and wherein a measured value of the time elapsed is taken into account when the procedure is selected.

5. The method of claim 3 or 4, wherein a first of the at least two procedures is adapted to minimise electrical switching losses while maintaining a changing rate and/or a peak value of an electric voltage at the valve, or at a driver circuit for controlling an operation of the valve, in particular a collector-emitter voltage within (a) specified limit(s) during the second process, and wherein the first procedure is selected if the time elapsed is longer than a threshold value, or is longer than or equal to a threshold value.

6. The method of one of claims 3 to 5, wherein a second of the at least two procedures is adapted to maintain a changing rate and/or a peak value of an electric voltage at the valve, or at a driver circuit for controlling an operation of the valve, in particular a collector-emitter voltage, within (a) specified limit(s) during the second process, and wherein the second procedure is selected if the time elapsed is shorter than a threshold value or is shorter than or equal to a threshold value.

7. The method of one of claims 3 to 6, wherein the time elapsed is compared to a comparison value and wherein a first of the at least two procedures is selected if the time elapsed up until an initiation of the second process is longer than the comparison value, or is longer than or equal to the comparison value.

8. The method of one of claims 3 to 7, wherein additional information concerning an operating state of the valve is taken into account when selecting the procedure of the second process.

9. The method of the preceding claim, wherein it is detected whether a collector-emitter-voltage of the valve (1) has decreased below a saturation voltage level during the first process and a corresponding detection result is obtained and
wherein the procedure of the second process is selected depending on the detection result.

10. The method of one of claims 1 to 9, wherein the first process is initiated by a control signal, in particular a first edge of a pulse signal, which is transferred to a driver device (13) for driving the gate (2), and wherein the elapsed time is measured starting at receipt of the control signal at the driver device (13).

11. An arrangement (13) for operating an electronic valve (1) having an insulated gate (2), in particular for operating an Insulated Gate Bipolar Transistor, comprising:
- a driver device (13) adapted to perform at least a part of a second process, wherein the second process is to be performed for switching off the valve (1),
**characterized by**
- a measuring device (22), adapted to measure a time elapsed from an initiation of a first process or from a characteristic point in time of the first process, wherein the first process is to be performed for switching on the valve (1),
- a selecting device (24), which is connected to the measuring device (22) and to the driver device (13), wherein the selecting device (24) is adapted to select an operation of the driver device (13) depending on a measurement signal received from the measuring device (22).

12. The arrangement of claim 11, wherein the driver device (13) comprises a first driver unit (17), adapted to perform at least a part of the second process and a second driver unit (18), adapted to perform the second process or at least a part of the second process in a different manner than the first driver unit (17).

13. The arrangement of claim 12, wherein the arrangement (13) comprises a gate connection (15) for discharging and/or charging the gate (2), and wherein the first (17) and second (18) driver unit are connected to the gate connection (15).

14. The arrangement of one of the preceding claims, wherein at least one of a plurality of driver units (17, 18) is controlled by an AND-device (27, 28), adapted to output a signal depending on the result of a logical AND-operation of two input signals, wherein the AND-device (27, 28) is connected to the selecting device (24) and to a signal input (23), adapted to receive a control signal for controlling, in particular initiating, the second process.

15. The arrangement of the preceding claim, wherein the signal input (23) is connected to the measuring device (22).

16. An arrangement for operating an electronic valve having an insulated gate, in particular for operating an Insulated Gate Bipolar Transistor, wherein the arrangement comprises:
- a driver device adapted to perform at least a part of a second process,
wherein the second process is to be performed for switching off the valve,
**characterized by**
- a measuring device adapted to measure a time elapsed from an initiation of a first process or from a characteristic point in time of the first process, wherein the first process is to be performed for switching on the valve, and
- a manipulating device, which is connected to the measuring device and to the driver device, wherein the manipulating device is adapted to cause the driver device to manipulate a gate current as a function of time during the second process, depending on an output signal of the measuring device.

17. The arrangement of one of claims 11 to 16, wherein the measuring device (22) comprises a clock signal input (21) for connecting the measuring device (22) to a clock signal generator.

18. A converter (3) for converting a current, in particular for a high power application such as providing electric energy to a driving motor (5) of a railroad traction vehicle, wherein the converter (3) comprises the arrangement (13) of one of claims 11 to 17, wherein the converter (3) can be operated by repeatedly switching the valve (1) on and off, and wherein the arrangement (13) and the gate (2) are connected to each other via a gate connection (15) for discharging and or charging the gate (2).

## Patentansprüche

1. Verfahren zum Betreiben eines elektronischen Ventils (1) mit isoliertem Gate (2), insbesondere zum Betreiben eines Bipolartransistors mit isoliertem Gate (IGBT), wobei
- ein erster Prozess ausgeführt wird, um das Ventil (1) einzuschalten,
- ein zweiter Prozess ausgeführt wird, um das Ventil (1) auszuschalten,
**dadurch gekennzeichnet, dass**
der zweite Prozess variiert wird in Abhängigkeit von der Zeit, die seit einer Initiierung des ersten Prozesses oder einem charakteristischen Zeitpunkt des ersten Prozesses verstrichen ist.

2. Verfahren nach dem vorhergehenden Anspruch, wobei ein Gatestrom als Funktion der Zeit manipuliert wird in Abhängigkeit von einem gemessenen Wert der verstrichenen Zeit.

3. Verfahren nach Anspruch 1 oder 2, wobei der zweite Prozess unter mindestens zwei Prozeduren ausgewählt wird, wobei die Zeit, die seit einer Initiierung des ersten Prozesses oder seit einem charakteristischen Zeitpunkt des ersten Prozesses verstrichen ist, berücksichtigt wird, wenn die Prozedur ausgewählt wird, und wobei sich die mindestens zwei Prozeduren im Hinblick auf einen Gatestrom als Funktion der Zeit unterscheiden.

4. Verfahren nach Anspruch 3, wobei die Zeit, die seit der Initiierung des ersten Prozesses oder seit dem charakteristischen Zeitpunkt des ersten Prozesses verstrichen ist, gemessen wird und wobei ein gemessener Wert der verstrichenen Zeit berücksichtigt wird, wenn die Prozedur ausgewählt wird.

5. Verfahren nach Anspruch 3 oder 4, wobei eine erste der mindestens zwei Prozeduren dazu gestaltet ist, elektrische Schaltverluste zu minimieren, bei gleichzeitiger Erhaltung einer Änderungsrate und/oder eines Maximalwertes einer elektrischen Spannung am Ventil, oder an einer Treiberschaltung zum Steuern eines Betriebes des Ventils, insbesondere einer Kollektor-Emitter-Spannung, innerhalb (eines) vorgegebenen(r) Grenzwerte(s) während des zweiten Prozesses, und wobei die erste Prozedur ausgewählt wird, wenn die verstrichene Zeit größer als ein Schwellwert ist, oder größer als oder gleich einem Schwellwert ist.

6. Verfahren nach einem der Ansprüche 3 bis 5, wobei eine zweite der mindestens zwei Prozeduren gestaltet ist zur Erhaltung einer Änderungsrate und/oder eines Maximalwertes einer elektrischen Spannung am Ventil, oder an einer Steuerschaltung zum Steuern eines Betriebes des Ventils, insbesondere einer Kollektor-Emitter-Spannung, innerhalb (eines) vorgegebenen(r) Grenzwerte(s) während des zweiten Prozesses, und wobei die zweite Prozedur ausgewählt wird, wenn die verstrichene Zeit kleiner als ein Schwellwert ist, oder kleiner als oder gleich einem Schwellwert ist.

7. Verfahren nach einem der Ansprüche 3 bis 6, wobei die verstrichene Zeit mit einem Vergleichswert verglichen wird und wobei eine erste der mindestens zwei Prozeduren ausgewählt wird, wenn die verstrichene Zeit bis zu einer Initiierung des zweiten Prozesses größer als der Vergleichswert ist, oder größer als oder gleich dem Vergleichswert ist.

8. Verfahren nach einem der Ansprüche 3 bis 7, wobei Zusatzinformationen über einen Betriebszustand des Ventils berücksichtigt werden, wenn die Prozedur des zweiten Prozesses ausgewählt wird.

9. Verfahren nach dem vorhergehenden Anspruch, wobei erfasst wird, ob eine Kollektor-Emitter-Spannung des Ventils (1) während des ersten Prozesses unter einen Sättigungsspannungspegel abgenommen hat und ein entsprechendes Erfassungsergebnis erreicht wird, und wobei die Prozedur des zweiten Prozesses in Abhängigkeit vom Erfassungsergebnis ausgewählt wird.

10. Verfahren nach einem der Ansprüche 1 bis 9, wobei der erste Prozess durch ein Steuersignal initiiert wird, insbesondere eine erste Flanke eines Pulssignals, das zu einer Treibervorrichtung (13) zum Treiben des Gates (2) übertragen wird, und wobei die verstrichene Zeit ab dem Empfang des Steuersignals an der Treibervorrichtung (13) gemessen wird.

11. Anordnung (13) zum Betreiben eines elektronischen Ventils (1) mit einem isolierten Gate (2), insbesondere zum Betreiben eines Bipolartransistors mit isoliertem Gate (IGBT), umfassend:
- eine Treibervorrichtung (13), die gestaltet ist zur Ausführung von mindestens einem Teil eines zweiten Prozesses, wobei der zweite Prozess auszuführen ist, um das Ventil (1) auszuschalten,
**gekennzeichnet durch**
- eine Messvorrichtung (22), die gestaltet ist zur Messung einer verstrichenen Zeit seit einer Initiierung eines ersten Prozesses oder einem charakteristischen Zeitpunkt des ersten Prozesses, wobei der erste Prozess auszuführen ist, um das Ventil (1) einzuschalten,
- eine Auswahlvorrichtung (24), die an die Messvorrichtung (22) und an die Steuervorrichtung (13) angeschlossen ist, wobei die Auswahlvorrichtung (24) dazu gestaltet ist, einen Betrieb der Treibervorrichtung (13) in Abhängigkeit von einem Messsignal, das von der Messvorrichtung (22) empfangen wird, auszuwählen.

12. Anordnung nach Anspruch 11, wobei die Treibervorrichtung (13) eine erste Treibereinheit (17) umfasst, die dazu gestaltet ist, mindestens einen Teil des zweiten Prozesses auszuführen, und eine zweite Treibereinheit (18), die dazu gestaltet ist, den zweiten Prozess oder mindestens einen Teil des zweiten Prozesses auf andere Art und Weise als die erste Treibereinheit (17) auszuführen.

13. Anordnung nach Anspruch 12, wobei die Anordnung (13) einen Gate-Anschluss (15) umfasst, um das Gate (2) zu entladen und/oder zu laden, und wobei die erste Treibereinheit (17) und die zweite (18) Treibereinheit mit dem Gate-Anschluss (15) verbunden sind.

14. Anordnung nach einem der vorhergehenden Ansprüche, wobei mindestens eine von einer Vielzahl von Treibereinheiten (17, 18) durch eine UND-Vorrichtung (27, 28) gesteuert wird, die dazu gestaltet ist, ein Signal in Abhängigkeit vom Ergebnis einer logischen UND-Verknüpfung von zwei Eingangssignalen abzugeben, wobei die UND-Vorrichtung (27, 28) verbunden ist mit der Auswahlvorrichtung (24) und mit einem Signaleingang (23), der dazu gestaltet ist, ein Steuersignal zum Steuern, und insbesondere zum Initiieren, des zweiten Prozesses zu empfangen.

15. Anordnung nach dem vorhergehenden Anspruch, wobei der Signaleingang (23) mit der Messvorrichtung (22) verbunden ist.

16. Anordnung zum Betreiben eines elektronischen Ventils mit einem isolierten Gate, insbesondere zum Betreiben eines Bipolartransistors mit isoliertem Gate (IGBT), wobei die Anordnung folgendes umfasst:
- eine Treibervorrichtung, die gestaltet ist zur Ausführung von mindestens einem Teil eines zweiten Prozesses, wobei der zweite Prozess auszuführen ist, um das Ventil auszuschalten,
**gekennzeichnet durch**
- eine Messvorrichtung, die geeignet ist zur Messung eines verstrichenen Zeitraums seit einer Initiierung eines ersten Prozesses oder einem charakteristischen Zeitpunkt des ersten Prozesses, wobei der erste Prozess auszuführen ist, um das Ventil einzuschalten, und
- eine Einstellungsvorrichtung, die an die Messvorrichtung und an die Treibervorrichtung angeschlossen ist, wobei die Einstellungsvorrichtung ausgestaltet ist, die Treibervorrichtung dazu zu veranlassen, einen Gatestrom als Funktion der Zeit während des zweiten Prozesses einzustellen, in Abhängigkeit von einem Ausgangssignal der Messvorrichtung.

17. Anordnung nach einem der Ansprüche 11 bis 16, wobei die Messvorrichtung (22) einen Taktsignaleingang (21) umfasst, um die Messvorrichtung (22) mit einem Taktsignalgenerator zu verbinden.

18. Wandler (3) zum Umwandeln eines Stroms, insbesondere für eine Hochleistungsanwendung wie die Versorgung mit Elektroenergie eines Antriebsmotors (5) von einem Schienentriebfahrzeug, wobei der Wandler (3) die Anordnung (13) nach einem der Ansprüche 11 bis 17 umfasst, wobei der Wandler (3) durch wiederholtes Ein- und Ausschalten des Ventils (1) betrieben werden kann, und wobei die Anordnung (13) und das Gate (2) über eine Gate-Verbindung (15) miteinander verbunden sind, um das Gate (2) zu entladen und/oder zu laden.

## Revendications

1. Procédé destiné à faire fonctionner une vanne électronique (1) ayant une grille isolée (2), en particulier destiné à faire fonctionner un transistor bipolaire de grille isolée, dans lequel
- un premier processus est effectué pour mettre la vanne (1) sous tension,
- un deuxième processus est effectué pour mettre la vanne (1) hors tension,
**caractérisé en ce que**
le deuxième processus varie en fonction du temps écoulé depuis un lancement du premier processus ou depuis un moment caractéristique du premier processus.

2. Procédé selon la revendication précédente, dans lequel un courant de grille en fonction du temps est manipulé d'après une valeur mesurée du temps écoulé.

3. Procédé selon la revendication 1 ou 2, dans lequel le deuxième processus est sélectionné parmi au moins deux procédures, dans lequel le temps écoulé depuis un lancement du premier processus ou depuis un moment caractéristique du premier processus est pris en compte lorsque la procédure est sélectionnée et dans lequel les au moins deux procédures diffèrent en ce qui concerne un courant de grille en fonction du temps.

4. Procédé selon la revendication 3, dans lequel le temps écoulé depuis le lancement du premier processus ou depuis le moment caractéristique du premier processus est mesuré et dans lequel une valeur mesurée du temps écoulé est prise en compte lorsque la procédure est sélectionnée.

5. Procédé selon la revendication 3 ou 4, dans lequel une première des au moins deux procédures est apte à minimiser les pertes de commutation électrique tout en maintenant un taux de changement et/ou une valeur de crête d'une tension électrique au niveau de la vanne, ou au niveau d'un circuit d'entraînement pour commander une opération de la vanne, en particulier une tension de collecteur-émetteur dans une ou des limites spécifiées au cours du deuxième processus, et dans lequel la première procédure est sélectionnée si le temps écoulé est supérieur à une valeur de seuil ou est supérieur ou égal à une valeur de seuil.

6. Procédé selon l'une des revendications 3 à 5, dans lequel une deuxième des au moins deux procédures est apte à maintenir un taux de changement et/ou une valeur de crête d'une tension électrique au niveau de la vanne, ou au niveau d'un circuit d'entraînement pour commander une opération de la vanne, en particulier une tension de collecteur-émetteur dans une ou des limites spécifiées au cours du deuxième processus, et dans lequel la deuxième procédure est sélectionnée si le temps écoulé est inférieur à une valeur de seuil ou est inférieur ou égal à une valeur de seuil.

7. Procédé selon l'une des revendications 3 à 6, dans lequel le temps écoulé est comparé à une valeur de comparaison et dans lequel une première des au moins deux procédures est sélectionnée si le temps écoulé jusqu'à un lancement du deuxième processus est supérieur à la valeur de comparaison, ou est supérieur ou égal à la valeur de comparaison.

8. Procédé selon l'une des revendications 3 à 7, dans lequel des informations complémentaires concernant un état de fonctionnement de la vanne sont prises en compte lors de la sélection de la procédure du deuxième processus.

9. Procédé selon la revendication précédente, dans lequel il est détecté si une tension de collecteur-émetteur de la vanne (1) a diminué au-dessous d'un niveau de tension de saturation au cours du premier processus et un résultat de détection correspondant est obtenu et dans lequel la procédure du deuxième processus est sélectionnée en fonction du résultat de détection.

10. Procédé selon l'une des revendications 1 à 9, dans lequel le premier processus est lancé par un signal de commande, en particulier un premier front d'un signal d'impulsion, qui est transféré à un dispositif d'entraînement (13) pour entraîner la grille (2), et dans lequel le temps écoulé est mesuré à partir de la réception du signal de commande au niveau du dispositif d'entraînement (13).

11. Agencement (13) destiné à faire fonctionner une vanne électronique (1) ayant une grille isolée (2), en particulier destiné à faire fonctionner un transistor bipolaire de grille isolée, comprenant :
- un dispositif d'entraînement (13) apte à effectuer au moins une partie d'un deuxième processus, dans lequel le deuxième processus doit être effectué pour mettre la vanne (1) hors tension,
**caractérisé par**
- un dispositif de mesure (22), apte à mesurer un temps écoulé depuis un lancement d'un premier processus ou depuis un moment caractéristique du premier processus, dans lequel le premier processus doit être effectué pour mettre la vanne sous tension (1),
- un dispositif de sélection (24), qui est connecté au dispositif de mesure (22) et au dispositif d'entraînement (13), dans lequel le dispositif de sélection (24) est apte à sélectionner une opération du dispositif d'entraînement (13) en fonction d'un signal de mesure reçu du dispositif de mesure (22).

12. Agencement selon la revendication 11, dans lequel le dispositif d'entraînement (13) comprend une première unité d'entraînement (17), apte à effectuer au moins une partie du deuxième processus et une deuxième unité d'entraînement (18), apte à effectuer le deuxième processus ou au moins une partie du deuxième processus d'une manière différente de la première unité d'entraînement (17).

13. Agencement selon la revendication 12, dans lequel l'agencement (13) comprend une connexion de grille (15) pour décharger et/ou charger la grille (2), et dans lequel la première unité d'entraînement (17) et la deuxième unité d'entraînement (18) sont connectées à la connexion de grille (15).

14. Agencement selon l'une des revendications précédentes, dans lequel au moins l'une d'une pluralité d'unités d'entraînement (17, 18) est commandée par un dispositif AND (27, 28), apte à délivrer un signal en fonction du résultat d'une opération AND logique de deux signaux d'entrée, dans lequel le dispositif AND (27, 28) est connecté au dispositif de sélection (24) et à une entrée du signal (23), apte à recevoir un signal de commande pour commander, en particulier pour lancer, le deuxième processus.

15. Agencement selon la revendication précédente, dans lequel l'entrée de signal (23) est connectée au dispositif de mesure (22).

16. Agencement destiné à faire fonctionner une vanne électronique ayant une grille isolée, en particulier destiné à faire fonctionner un transistor bipolaire de grille isolée, dans lequel l'agencement comprend :
- un dispositif d'entraînement apte à effectuer au moins une partie d'un deuxième processus, dans lequel le deuxième processus doit être effectué pour mettre la vanne hors tension;
**caractérisé par**:
- un dispositif de mesure apte à mesurer un temps écoulé depuis un lancement d'un premier processus ou depuis un moment caractéristique du premier processus, dans lequel le premier processus doit être effectué pour mettre la vanne sous tension (1), et
- un dispositif de manipulation, qui est connecté au dispositif de mesure et au dispositif d'entraînement, dans lequel le dispositif de manipulation est apte à amener le dispositif d'entraînement à manipuler un courant de grille en fonction du temps pendant le deuxième processus d'après un signal de sortie du dispositif de mesure.

17. Agencement selon l'une des revendications 11 à 16, dans lequel le dispositif de mesure (22) comprend une entrée de signal d'horloge (21) pour connecter le dispositif de mesure (22) à un générateur de signal d'horloge.

18. Convertisseur (3) pour convertir un courant, en particulier pour une application de grande puissance comme pour fournir de l'énergie électrique à un moteur d'entraînement (5) d'un véhicule de traction ferroviaire, dans lequel le convertisseur (3) comprend l'agencement (13) selon l'une des revendications 11 à 17, dans lequel le convertisseur (3) peut être exploité en mettant la vanne (1) sous tension et hors tension à répétition, et dans lequel l'agencement (13) et la grille (2) sont connectés l'un à l'autre par l'intermédiaire d'une connexion de grille (15) pour décharger et/ou charger la grille (2).
